# EUROPEAN PATENT APPLICATION

(11) **EP 3 817 519 A1**
(43) Date of publication of application: **05.05.2021**
(21) Application number: 19825673.7
(22) Date of filing: 18.06.2019
(51) Int. Cl.: H05K 1/02, H01L 31/054, H02S 40/22

(54) **ORIGINAL FORM BODY OF FLEXIBLE PRINTED-WIRING BOARD, METHOD OF MANUFACTURING FLEXIBLE PRINTED-WIRING BOARD, CONCENTRATED PHOTOVOLTAIC POWER GENERATION MODULE, AND LIGHT EMITTING MODULE**

(30) Priority: 27.06.2018 JP 2018121660
(71) Applicant: SUMITOMO ELECTRIC INDUSTRIES, LTD., Osaka-shi, Osaka 541-0041 (JP)
(72) Inventor: SAITO, Kenji, Osaka-shi, Osaka 541-0041 (JP); KOIKE, Yukio, Osaka-shi, Osaka 541-0041 (JP); NAGAI, Youichi, Osaka-shi, Osaka 541-0041 (JP); TOYA, Kazumasa, Osaka-shi, Osaka 541-0041 (JP)
(74) Representative: Boult Wade Tennant LLP
(86) International application number: PCT/JP2019/024095
(87) International publication number: WO 2020/004144

(57) **Abstract**

A precursor body, of a flexible printed circuit, which is developed and provided on a bottom surface of a housing of a concentrator photovoltaic module for concentrating sunlight and generating power, includes: a plurality of strip-shaped flexible substrates extending in an X direction when one direction is defined as the X direction; a printed circuit unit including a plurality of cells mounted on the flexible substrates at equal intervals in the X direction and an electric circuit related to the cells; and a plurality of connection bands connecting the plurality of flexible substrates to each other in a state where the plurality of flexible substrates are aligned so as to be close to each other in a Y direction orthogonal to the X direction, the plurality of connection bands extending in the Y direction.

## Description

### TECHNICAL FIELD

The present invention relates to a precursor body of a flexible printed circuit, a manufacturing method for a flexible printed circuit, a concentrator photovoltaic module, and a light emitting module.

This application claims priority on Japanese Patent Application No. 2018-121660 filed on June 27, 2018, the entire contents of which are incorporated herein by reference.

### BACKGROUND ART

A flexible substrate can be used as a substrate on which cells or the like in a concentrator photovoltaic module are mounted (see, for example, PATENT LITERATURES 1 and 2). Since the cells only need to be at a position where sunlight is concentrated, a strip-shaped substrate rather than a planar substrate is more convenient in terms of cost. The flexible substrate is a substrate made of polyimide and is highly flexible, and thus the flexible substrate can be spread over the bottom surface of a large housing of a condenser photovoltaic module or the like, and the cells can be placed thereon. At the time of manufacture, flexible substrates are produced in a dense form in order to improve the yield. A thin release paper is attached to one surface of a precursor body of such a flexible printed circuit in order to prevent shape deformation during transportation.

### CITATION LIST

### [PATENT LITERATURE]

PATENT LITERATURE 1: Japanese Laid-Open Patent Publication No. 2016-18991
PATENT LITERATURE 2: Japanese Laid-Open Patent Publication No. 2017-126777

### SUMMARY OF INVENTION

The present disclosure includes the following invention. However, the present invention is defined by the claims.

### <<Precursor body of flexible printed circuit>>

A precursor body of a flexible printed circuit according to an aspect of the present invention is a precursor body, of a flexible printed circuit, which is developed and provided on a bottom surface of a housing of a concentrator photovoltaic module for concentrating sunlight and generating power, the precursor body including: a plurality of strip-shaped flexible substrates extending in an X direction when one direction is defined as the X direction; a printed circuit unit including a plurality of cells mounted on the flexible substrates at equal intervals in the X direction and an electric circuit related to the cells; and a plurality of connection bands connecting the plurality of flexible substrates to each other in a state where the plurality of flexible substrates are aligned so as to be close to each other in a Y direction orthogonal to the X direction, the plurality of connection bands extending in the Y direction.

### <<Manufacturing method for flexible printed circuit>>

A manufacturing method for a flexible printed circuit according to an aspect of the present invention includes: mounting a printed circuit unit including an electric circuit, on a plurality of strip-shaped flexible substrates extending in an X direction when one direction is defined as the X direction; preparing a precursor body of the flexible printed circuit by, in a state where the plurality of flexible substrates are aligned so as to be close to each other in a Y direction orthogonal to the X direction, making the plurality of flexible substrates connected to each other by a plurality of connection bands extending in the Y direction; cutting each of the connection bands at an intermediate position between two adjacent flexible substrates such that the flexible substrates are separated from each other in the Y direction, when mounting to an installation target; and developing the plurality of flexible substrates separated from each other, into a desired shape to form the flexible printed circuit.

### <<Concentrator photovoltaic module>>

A concentrator photovoltaic module according to an aspect of the present invention is a concentrator photovoltaic module for concentrating sunlight and generating power, the concentrator photovoltaic module including: a housing; a concentrating portion mounted so as to face a bottom surface of the housing; and a flexible printed circuit provided on the bottom surface of the housing so as to form a plurality of rows, wherein the flexible printed circuit in each row includes a strip-shaped flexible substrate extending in an X direction when one direction is defined as the X direction, a printed circuit unit including a plurality of cells which are mounted on the flexible substrate at equal intervals in the X direction and are for performing photoelectric conversion by sunlight concentrated by the concentrating portion and an electric circuit related to the cells, and a remnant of a connection band remaining at the flexible substrate and extending in a Y direction orthogonal to the X direction.

### <<Light emitting module>>

A light emitting module according to an aspect of the present invention is a light emitting module for emitting light upon receiving power supplied from outside, the light emitting module including: a housing; a light-transmissive plate mounted so as to face a bottom surface of the housing; and a flexible printed circuit provided on the bottom surface of the housing so as to form a plurality of rows, wherein the flexible printed circuit in each row includes a strip-shaped flexible substrate extending in an X direction when one direction is defined as the X direction, a printed circuit unit including light emitting elements mounted on the flexible substrate at equal intervals in the X direction and an electric circuit related to the light emitting elements, and a remnant of a connection band remaining at the flexible substrate and extending in a Y direction orthogonal to the X direction.

### BRIEF DESCRIPTION OF DRAWINGS

FIG. 1 is a perspective view of an example of one concentrator photovoltaic apparatus, viewed from the light receiving surface side, and shows the photovoltaic apparatus in a completed state.
FIG. 2 is a perspective view of an example of one concentrator photovoltaic apparatus, viewed from the light receiving surface side, and shows the photovoltaic apparatus in a state of being assembled.
FIG. 3 is a perspective view showing, as an example, an attitude of an array facing the sun directly from the front.
FIG. 4 is a perspective view showing an example of a configuration of a concentrator photovoltaic module.
FIG. 5 is a cross-sectional view showing a configuration example of a light receiving portion of the concentrator photovoltaic module.
FIG. 6 is a cross-sectional view showing an example of a concentrator photovoltaic unit as a basic configuration of an optical system, for concentrate-type power generation, forming the concentrator photovoltaic module.
FIG. 7 shows an example of a precursor body of a flexible printed circuit before being developed.
FIG. 8 is a perspective view of a part of the precursor body of the flexible printed circuit as viewed obliquely from above.
FIG. 9 is a Y-Z cross-sectional view of a portion where a connection band is present.
FIG. 10 shows a procedure for separating the connection band of the precursor body.
FIG. 11 is a plan view of, for example, a part of four flexible substrates when mounting the flexible substrates to the bottom surface of a housing.
FIG. 12 is a plan view showing a part in a state where developed flexible substrates are mounted on heat radiation tapes attached to the bottom surface of the housing.
FIG. 13 is a plan view of the connection band before separation, focusing only on two adjacent flexible substrates.
FIG. 14 is a plan view showing a first example of a positioning procedure using a connection band remaining at a flexible substrate.
FIG. 15 is a plan view showing a second example of the positioning procedure using the connection band remaining at the flexible substrate.
FIG. 16 is a plan view showing a third example of the positioning procedure using the connection band remaining at the flexible substrate.
FIG. 17 is a plan view showing a fourth example of the positioning procedure using the connection band remaining at the flexible substrate.

### DESCRIPTION OF EMBODIMENTS

### [Problems to be solved by the present disclosure]

When the release paper described above is used for the flexible printed circuit, man-hours for attaching the release paper are required, the cost of the release paper itself is not low, and the release paper is finally peeled off and thrown away. In addition, in a production line, when the release paper is sucked and peeled off using a dedicated machine, since the flexible printed circuit is thin and flexible, there is a problem that, due to the suction, the flexible printed circuit may be sucked together with the release paper, resulting in deformation or damage of the flexible printed circuit. However, if the release paper is omitted, since the flexible printed circuit is an assembly of strip-shaped thin objects, it is not easy to handle the flexible printed circuit.

In view of the above problems, an object of the present disclosure is to make a precursor body of a flexible printed circuit easy to handle without depending on a release paper.

### [Effects of the present disclosure]

According to the present disclosure, it is possible to make a precursor body of a flexible printed circuit easy to handle without depending on a release paper.

### [Summary of embodiments]

A summary of embodiments of the present disclosure includes at least the following.
(1) This is a precursor body, of a flexible printed circuit, which is developed and provided on a bottom surface of a housing of a concentrator photovoltaic module for concentrating sunlight and generating power, the precursor body including: a plurality of strip-shaped flexible substrates extending in an X direction when one direction is defined as the X direction; a printed circuit unit including a plurality of cells mounted on the flexible substrates at equal intervals in the X direction and an electric circuit related to the cells; and a plurality of connection bands connecting the plurality of flexible substrates to each other in a state where the plurality of flexible substrates are aligned so as to be close to each other in a Y direction orthogonal to the X direction, the plurality of connection bands extending in the Y direction.
   In the precursor body of the flexible printed circuit described above, since the plurality of flexible substrates are connected by the connection bands, the plurality of flexible substrates are inhibited from overlapping each other or twisting, and thus can be handled as a single sheet. Therefore, it is easy to handle the precursor body of the flexible printed circuit even when a release paper is not used. When mounting, each connection band is cut at the intermediate position in the Y direction, and the flexible substrates are separated from each other. In addition, the connection bands remaining after separation can serve as marks for proper mounting or positioning of the flexible printed circuit, and also have the effect of making the adhesion of the entire flexible printed circuit strong, when the connection bands are adhered to an installation surface.
(2) In the precursor body of the flexible printed circuit of (1), a copper pattern having a shape that makes it easy to cut the copper pattern at an intermediate position in the Y direction and that makes it difficult to cut the copper pattern at a position other than the intermediate position may be provided on one face of each connection band.
   In this case, when cutting the connection band, cutting or tearing that results in an unintended end face shape is less likely to occur, and thus the certainty that cutting with a desired end face shape is performed can be increased.
(3) In the precursor body of the flexible printed circuit of (1), a perforation may be formed at an intermediate position in the Y direction of each connection band.
   In this case, when cutting the connection band, cutting or tearing that results in an unintended end face shape is less likely to occur, and thus the certainty that cutting with a desired end face shape is performed along the perforation can be increased. Moreover, the connection band can be easily cut even without using a machine dedicated for cutting.
(4) According to an aspect of a manufacturing method, a manufacturing method for a flexible printed circuit includes: mounting a printed circuit unit including an electric circuit, on a plurality of strip-shaped flexible substrates extending in an X direction when one direction is defined as the X direction; preparing a precursor body of the flexible printed circuit by, in a state where the plurality of flexible substrates are aligned so as to be close to each other in a Y direction orthogonal to the X direction, making the plurality of flexible substrates connected to each other by a plurality of connection bands extending in the Y direction; cutting each of the connection bands at an intermediate position between two adjacent flexible substrates such that the flexible substrates are separated from each other in the Y direction, when mounting to an installation target; and developing the plurality of flexible substrates separated from each other, into a desired shape to form the flexible printed circuit.
   In the manufacturing method for the flexible printed circuit as described above, since the plurality of flexible substrates are connected by the connection bands at the stage of the precursor body, the plurality of flexible substrates are inhibited from overlapping each other or twisting, and thus can be handled as a single sheet. Therefore, it is easy to handle the precursor body of the flexible printed circuit even when a release paper is not used. In addition, the connection bands remaining after separation can serve as marks for proper mounting or positioning of the flexible printed circuit, and also have the effect of making the adhesion of the entire flexible printed circuit strong, when the connection bands are adhered to an installation surface.
(5) In the manufacturing method for the flexible printed circuit of (4), the connection band may be cut such that a recess or a projection is left at a cut portion in the Y direction of the connection band at the adjacent flexible substrates.
   In this case, the recess or the projection remaining after separation can be used as a mark for positioning when mounting the flexible printed circuit. Therefore, accurate mounting can be easily performed.
(6) In the manufacturing method for the flexible printed circuit of (4), a mark with which the connection band after separation is aligned may be formed on an installation surface of the installation target.
   In this case, the connection band remaining after separation can be used to accurately position each portion of the flexible substrate.
(7) Another aspect is directed to a concentrator photovoltaic module for concentrating sunlight and generating power, the concentrator photovoltaic module including: a housing; a concentrating portion mounted so as to face a bottom surface of the housing; and a flexible printed circuit provided on the bottom surface of the housing so as to form a plurality of rows, wherein the flexible printed circuit in each row includes a strip-shaped flexible substrate extending in an X direction when one direction is defined as the X direction, a printed circuit unit including a plurality of cells which are mounted on the flexible substrate at equal intervals in the X direction and are for performing photoelectric conversion by sunlight concentrated by the concentrating portion and an electric circuit related to the cells, and a remnant of a connection band remaining at the flexible substrate and extending in a Y direction orthogonal to the X direction.
   In the concentrator photovoltaic module described above, the connection bands that connect a plurality of the flexible substrates before mounting are cut when mounting, and remnants of the connection bands extending in the Y direction remain. By adhering the remnants to a mounting surface, the adhesion of the flexible substrates to the mounting surface becomes more stable and reliable, so that the adhesion of the entire flexible printed circuit can be made strong. Moreover, the connection bands remaining after separation can also serve as marks for proper mounting or positioning of the flexible printed circuit.
(8) A light emitting module having a similar structure may be provided. Specifically, the light emitting module is a light emitting module for emitting light upon receiving power supplied from outside, the light emitting module including: a housing; a light-transmissive plate mounted so as to face a bottom surface of the housing; and a flexible printed circuit provided on the bottom surface of the housing so as to form a plurality of rows, wherein the flexible printed circuit in each row includes a strip-shaped flexible substrate extending in an X direction when one direction is defined as the X direction, a printed circuit unit including light emitting elements mounted on the flexible substrate at equal intervals in the X direction and an electric circuit related to the light emitting elements, and a remnant of a connection band remaining at the flexible substrate and extending in a Y direction orthogonal to the X direction.

### [Details of embodiments]

Hereinafter, a manufacturing method for a flexible printed circuit, a precursor body of a flexible printed circuit, and a concentrator photovoltaic module according to an embodiment of the present invention will be described with reference to the drawings.

### <<Concentrator photovoltaic apparatus>>

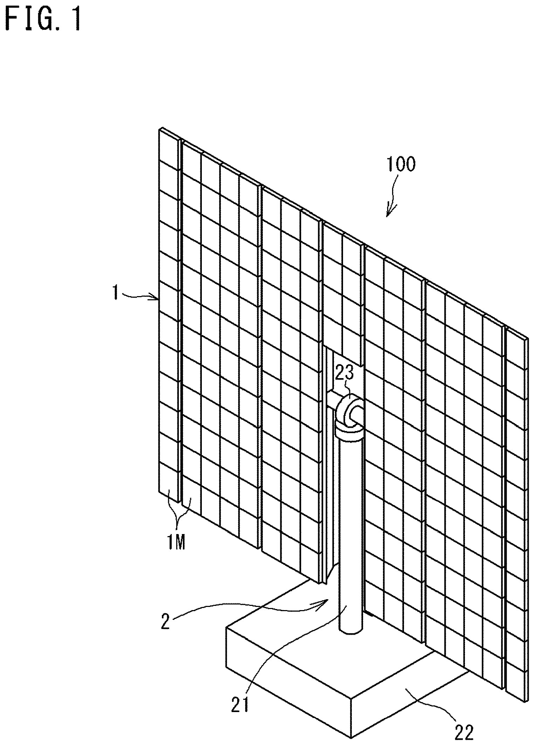

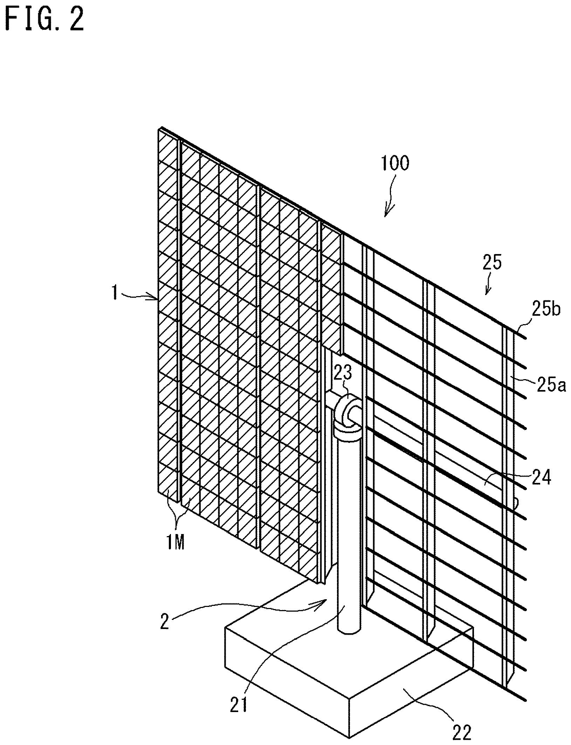

FIG. 1 and FIG. 2 are each a perspective view of an example of one concentrator photovoltaic apparatus viewed from the light receiving surface side. FIG. 1 shows a photovoltaic apparatus 100 in a completed state, and FIG. 2 shows the photovoltaic apparatus 100 in a state of being assembled. The right half of FIG. 2 shows a state where the framework of a tracker 25 is seen, and the left half of FIG. 2 shows a state where concentrator photovoltaic modules (hereinafter, also referred to simply as modules) 1M are mounted. In actuality, when the modules 1M are to be mounted to the tracker 25, mounting is performed in a state where the tracker 25 is laid on the ground.

In FIG. 1, the photovoltaic apparatus 100 includes: an array (the entire photovoltaic panel) 1 having a shape that is continuous on the upper side and is divided into right and left portions on the lower side; and a support device 2 therefor. The array 1 is formed by arraying the modules 1M on the tracker 25 (FIG. 2) disposed on the rear side. In the example shown in FIG. 1, the array 1 is formed as an assembly composed of 200 modules 1M in total, i.e., (96(=12×8)×2) modules forming the right and left wings and 8 modules 1M forming the connection portion at the center.

The support device 2 includes a post 21, a base 22, a biaxial drive part 23, and a horizontal shaft 24 (FIG. 2) serving as a drive shaft. The lower end of the post 21 is fixed to the base 22, and the upper end of the post 21 is provided with the biaxial drive part 23.

In FIG. 1, the base 22 is firmly embedded in the ground to an extent that only the upper face of the base 22 is seen. In the state where the base 22 is embedded in the ground, the post 21 extends vertically, and the horizontal shaft 24 (FIG. 2) extends horizontally. The biaxial drive part 23 can rotate the horizontal shaft 24 in two directions of azimuth (angle around the post 21 as the central axis) and elevation (the angle around the horizontal shaft 24 as the central axis). In FIG. 2, a reinforcement member 25a that reinforces the tracker 25 is mounted to the horizontal shaft 24. In addition, a plurality of rails 25b extending in the horizontal direction are mounted to the reinforcement member 25a. Therefore, if the horizontal shaft 24 is rotated in the direction of azimuth or elevation, the array 1 is also rotated in that direction.

Usually, the array 1 extends vertically as in FIG. 1 at dawn and before sunset.

During the daytime, the biaxial drive part 23 operates such that the light receiving surface of the array 1 takes an attitude of always facing the sun directly from the front, and the array 1 performs an operation of tracking the sun.

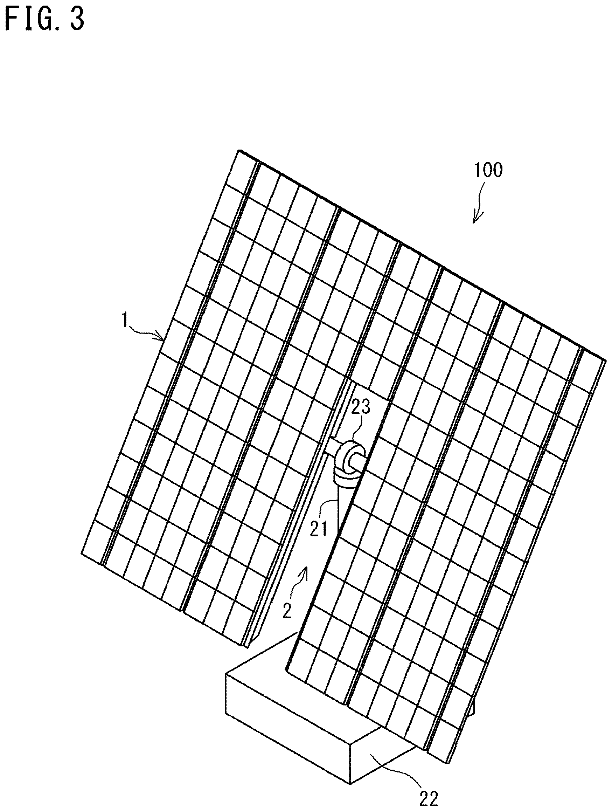

FIG. 3 is a perspective view showing, as an example, an attitude of the array 1 facing the sun directly from the front. For example, at the culmination time at a place near the equator, the array 1 takes a horizontal attitude, with the light receiving surface directed toward the sun. During the nighttime, for example, the array 1 takes a horizontal attitude, with the light receiving surface directed toward the ground.

### <<Configuration example of concentrator photovoltaic module>>

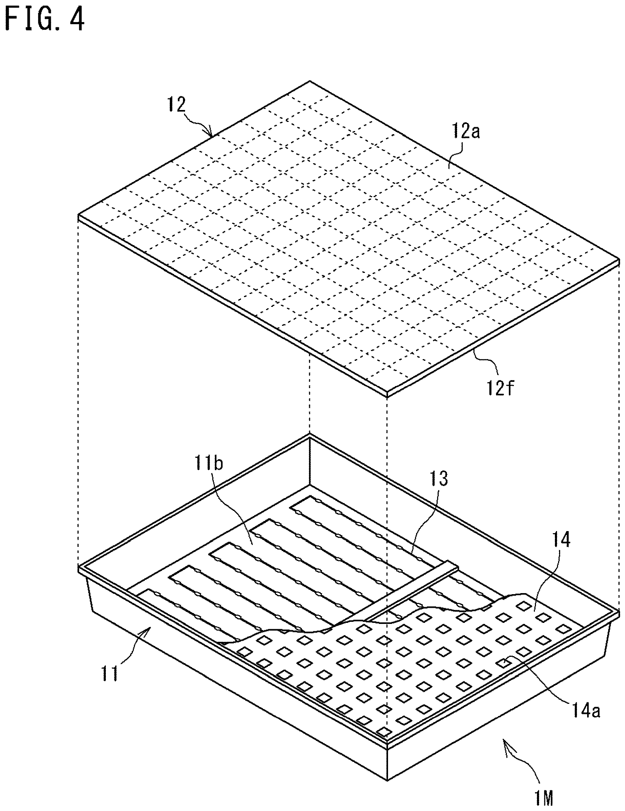

FIG. 4 is a perspective view showing an example of a configuration of the concentrator photovoltaic module 1M. However, on the bottom surface 11b side, only a flexible printed circuit 13 is shown, and other components are not shown.

In terms of the appearance of the physical form, the module 1M includes: a housing 11 made of, for example, metal or resin and having a rectangular flat-bottomed container shape; and a concentrating portion 12 mounted, like a cover, on the housing 11. The concentrating portion 12 is formed by attaching resin primary lenses (Fresnel lenses) 12f to the back face of a single light-transmissive glass plate 12a, for example. For example, each of the indicated square sections (in this example, 14 squares × 10 squares, but the number is merely an example for description) is a primary lens 12f, and can cause sunlight to be converged at the focal point.

On the bottom surface 11b of the housing 11, for example, in each of the left half and the right half of the housing 11, the one slender flexible printed circuit 13 is disposed so as to be arrayed by being turned as shown. The flexible printed circuit 13 has a relatively wide portion and a relatively narrow portion. Each cell (not shown) is mounted on the wide portion. Each cell is disposed at a position corresponding to the optical axis of each Fresnel lens 12f.

A shielding plate 14 made of metal, for example, is mounted between the flexible printed circuit 13 and the concentrating portion 12. In the shielding plate 14, at positions corresponding to the centers of the individual primary lenses 12f, square openings 14a each having a shape similar to the square of the primary lens 12f are formed. When the array 1 accurately tracks the sun and the angle of incidence of sunlight with respect to the module 1M is 0 degrees, light concentrated by the primary lens 12f can pass through the opening 14a. When the tracking is greatly deviated, concentrated light is blocked by the shielding plate 14. However, when the tracking is slightly deviated, concentrated light passes through the opening 14a.

### <<Configuration example of light receiving portion>>

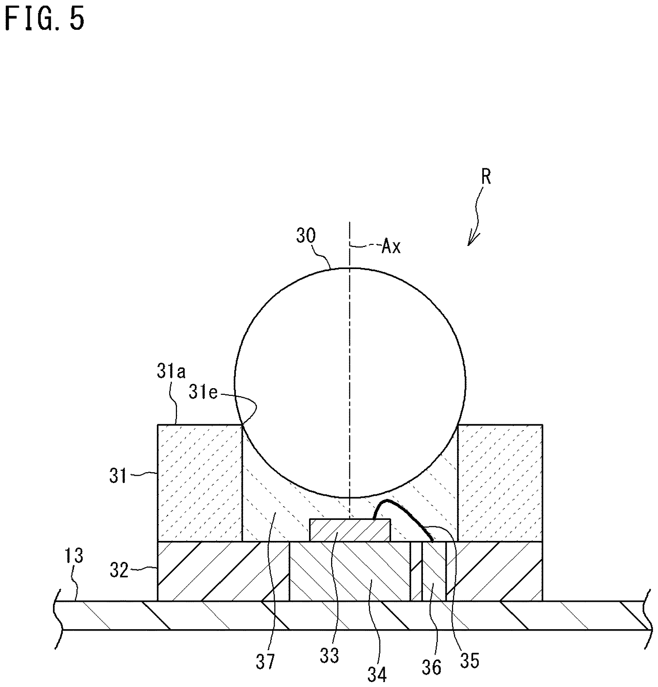

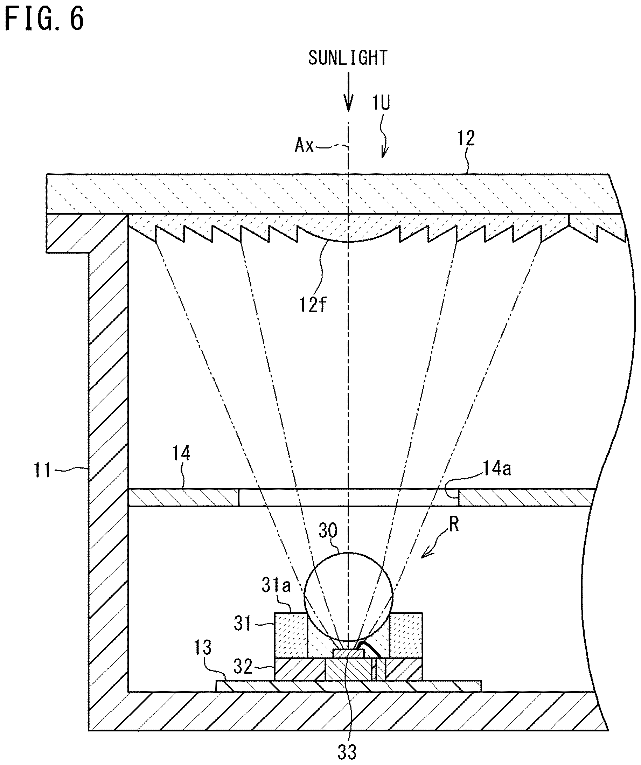

FIG. 5 is a cross-sectional view showing a configuration example of a light receiving portion R of the concentrator photovoltaic module. Each portion in FIG. 5 is expressed in an enlarged manner as appropriate for convenience for describing the structure, and is not necessarily proportional to the actual dimensions (the same applies to FIG. 6).

In FIG. 5, the light receiving portion R includes a secondary lens 30, a support portion 31, a package 32, a cell 33, a lead frame (P side) 34, a gold wire 35, a lead frame 36 (N side), and a sealing portion 37. The light receiving portion R is mounted on the flexible printed circuit 13. A bypass diode is connected to the cell 33 in parallel, but is not shown.

The secondary lens 30 is, for example, a ball lens. The secondary lens 30 is supported by an upper end inner peripheral edge 31e of the support portion 31 such that a gap in an optical axis Ax direction is formed between the cell 33 and the secondary lens 30. The support portion 31 is, for example, cylindrical, and is made of resin or glass. The support portion 31 is fixed on the flat package 32. The package 32 is made of resin and holds the cell 33 together with the lead frames 34 and 36. The output of the cell 33 is drawn to the lead frame 34 on the P side and to the lead frame 36 via the gold wire 35 on the N side. The sealing portion 37 is a light-transmissive silicone resin and is provided so as to fill the space formed between the secondary lens 30 and the cell 33 inside the support portion 31.

In FIG. 5, an upper end portion of the support portion 31 is formed such that an end face 31a extends on the outer side of the secondary lens 30 with the optical axis Ax as a center. When the support portion 31 is made of resin, a washer-shaped metal protective plate may be placed on the end face 31a.

### <<Configuration example of concentrator photovoltaic unit>>

FIG. 6 is a cross-sectional view showing an example of a concentrator photovoltaic unit 1U as a basic configuration of an optical system, for concentrate-type power generation, forming the module 1M.

In the drawing, when the concentrator photovoltaic unit 1U faces the sun directly from the front and the angle of incidence of sunlight is 0 degrees, the secondary lens 30 and the cell 33 of the light receiving portion R are present on the optical axis Ax of the primary lens 12f. Light concentrated by the primary lens 12f passes through the opening 14a of the shielding plate 14, is taken in by the secondary lens 30 of the light receiving portion R, and is guided to the cell 33.

### <<Precursor body of flexible printed circuit>>

Next, the flexible printed circuit 13 shown in FIG. 4 will be described in detail. In FIG. 4, the flexible printed circuit 13 is developed and mounted on the bottom surface 11b of the housing 11.

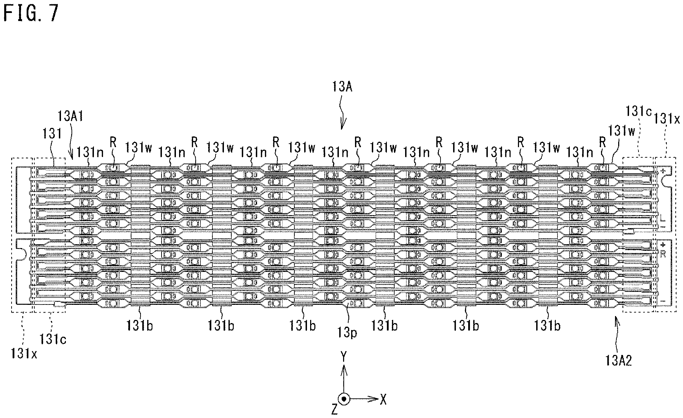

Meanwhile, FIG. 7 shows an example of a precursor body 13A of the flexible printed circuit 13 before being developed. In the drawing, the precursor body 13A includes 140 light receiving portions R. When the precursor body 13A is developed, the number of light receiving portions R corresponds to the total number of primary lenses 12f (FIG. 4). The number is merely an example, and in short, a flexible printed circuit 13 on which light receiving portions R, the number of which corresponds to the total number of primary lenses 12f, are mounted is required.

Here, mutually orthogonal three directions shown in FIG. 7 are defined as an X direction, a Y direction, and a Z direction. In the precursor body 13A, the light receiving portions R, etc., have a certain height in the Z direction, but, when a general view of the overall form of the precursor body 13A is taken, the precursor body 13A has a single-sheet shape on the X-Y plane. However, electrical connection is separated between the upper half and the lower half in the Y direction of the precursor body 13A, and the precursor body 13A is composed of an upper-half precursor body 13A1 and a lower-half precursor body 13A2.

For example, in the upper-half precursor body 13A1, 10 strip-shaped flexible substrates 131 extending in the X direction are provided so as to be close to each other in the Y direction. The 10 flexible substrates 131 are electrically connected in series as a whole while changing the direction so as to fold back at the left end and the right end. In each flexible substrate 131, a wide portion 131w that is relatively wide in the Y direction is formed at each of portions where the light receiving portions R are mounted, and a narrow portion 131n that is relatively narrow is formed between two light receiving portions R adjacent to each other in the X direction.

The lower-half precursor body 13A2 is also formed in the same manner, and the precursor body 13A includes 20 flexible substrates 131 as a whole.

The positions in the X direction of the wide portions 131w of two flexible substrates 131 adjacent to each other in the Y direction can be shifted relative to each other. Accordingly, the 20 flexible substrates 131 can be made dense as a whole, thereby enabling high-yield production. Folded portions 131c at the left end and the right end are folded with the same width as the narrow portion 131n, and, by utilizing the thinness, the folded portions 131c can be freely spread in the Y direction and shifted in the X direction, thereby allowing the precursor body 13A (13A1, 13A2) to be developed into a desired shape.

Each of six connection bands 131b extending in the Y direction connects the 20 flexible substrates 131 to each other in a state where the flexible substrates 131 are aligned so as to be close to each other. Accordingly, the entire precursor body 13A including the 20 flexible substrates 131 has a single-sheet shape and is easily handled. Margin portions 131x at the left and right ends are portions provided due to the necessity for manufacturing, and are cut off before the precursor body 13A is mounted as a flexible printed circuit.

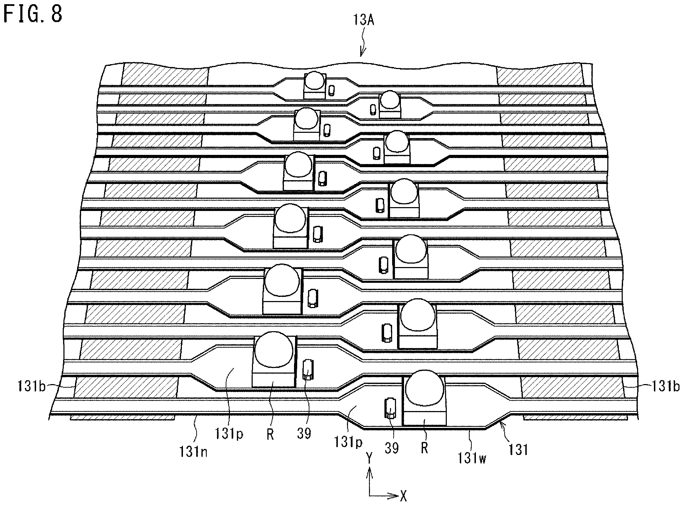

FIG. 8 is a perspective view of a part of the precursor body 13A of the flexible printed circuit 13 as viewed obliquely from above. The connection bands 131b are shown with diagonal lines. With the strip-shaped flexible substrates 131 extending in the X direction as bases, a printed circuit unit 131p that includes: the light receiving portions R mounted at equal intervals in the X direction; and an electric circuit related to the light receiving portions R, is mounted on the flexible substrates 131. A bypass diode 39, which is also a part of the printed circuit unit 131p, is provided near each light receiving portion R. Since each flexible substrate 131 is folded back at each end in the X direction as described above, the polarities of two adjacent flexible substrates 131 are opposite to each other.

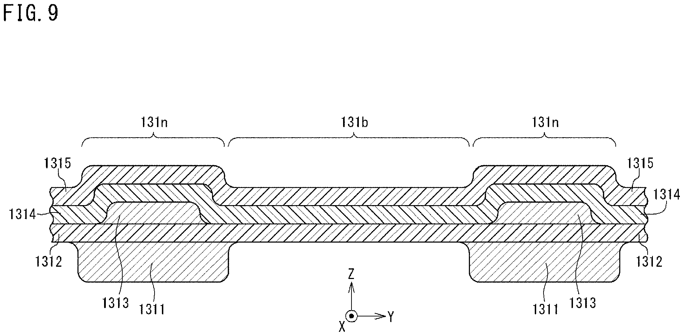

FIG. 9 is a Y-Z cross-sectional view of a portion where the connection band 131b is present. X, Y, and Z directions which are three directions orthogonal to each other are the same as in FIG. 7. Each narrow portion 131n of the flexible substrate 131 has a configuration in which, for example, a copper pattern 1311 on the back face, an insulating base portion 1312 made of polyimide, a copper pattern 1313 on the front face side, an adhesive layer 1314, and a cover lay 1315 made of polyimide are stacked. The connection band 131b is, for example, configured by extending the insulating base portion 1312, the adhesive layer 1314, and the cover lay 1315 as they are.

### < <Development from precursor body to flexible printed circuit> >

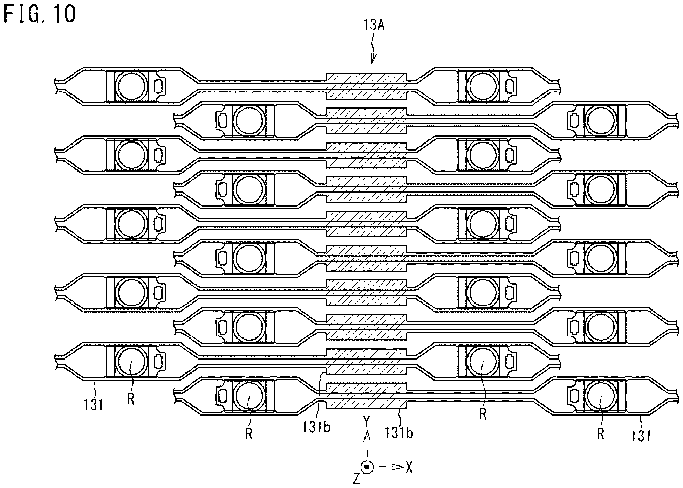

FIG. 10 shows a procedure for separating the connection band 131b of the precursor body 13A. By cutting the connection band 131b between two adjacent flexible substrates 131, for example, at the intermediate position in the Y direction, each flexible substrate 131 can be separated from each other. After the separation, the flexible substrates 131 are shifted in the X direction such that the positions in the X direction of the light receiving portions R are aligned with each other.

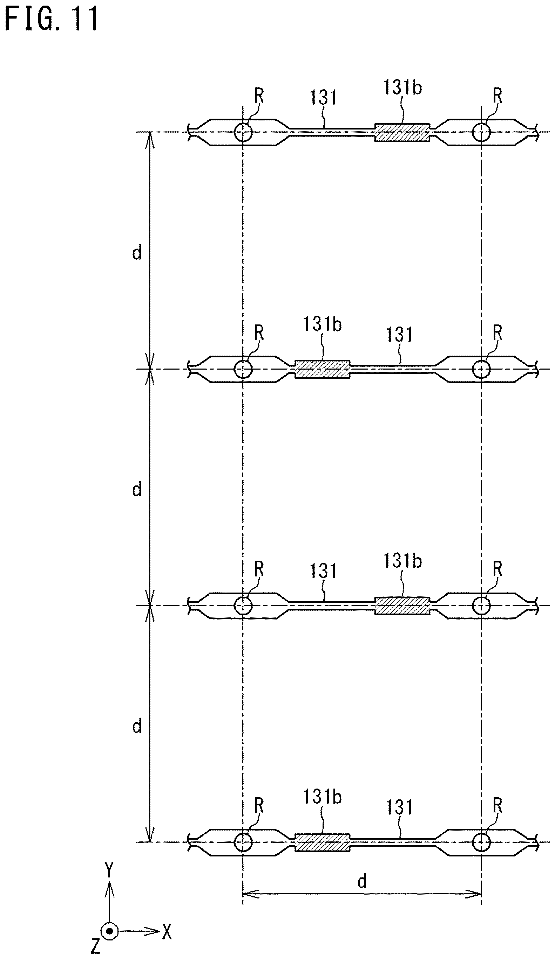

FIG. 11 is a plan view of, for example, a part of four flexible substrates 131 when mounting the flexible substrates 131 to the bottom surface 11b (FIG. 4) of the housing 11. The distance d between two light receiving portions R adjacent to each other in the X direction and the distance d between two light receiving portions R adjacent to each other in the Y direction are the same. These distances d are the same as the vertical and horizontal intervals of a matrix at the optical axis center of the primary lens 12f (FIG. 4). In FIG. 11, the connection band 131b (connection band as a remnant) remains at each flexible substrate 131.

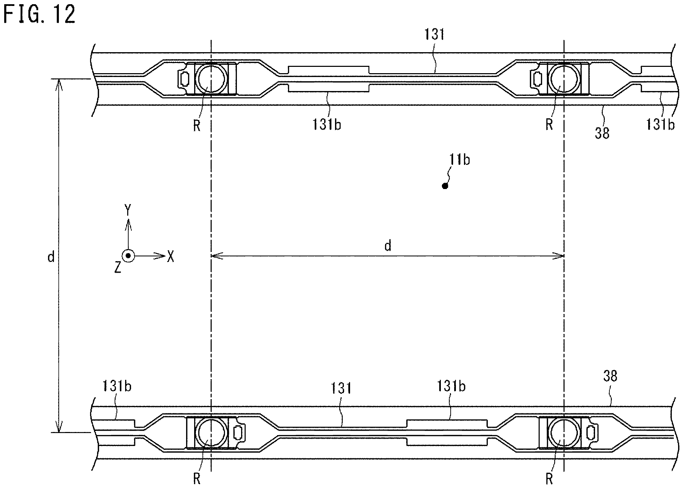

FIG. 12 is a plan view showing a part in a state where the developed flexible substrates 131 are mounted on heat radiation tapes 38 attached to the bottom surface 11b of the housing 11. By adhering the connection bands 131b remaining in the shape of a "fin" to the heat radiation tapes 38, the connection bands 131b assist the adhesion of the flexible substrates 131, so that the adhesion of the entire flexible printed circuit 13 becomes stronger. In addition, the connection bands 131b also serve as positioning marks when mounting, as will be described later. Furthermore, the connection bands 131b also serve as marks indicating polarity. That is, it can be recognized at a glance that the polarity is positive (or negative) on the side on which the connection band 131b is present when a certain distance range from the light receiving portion R is viewed.

### <<Other form of connection bands>>

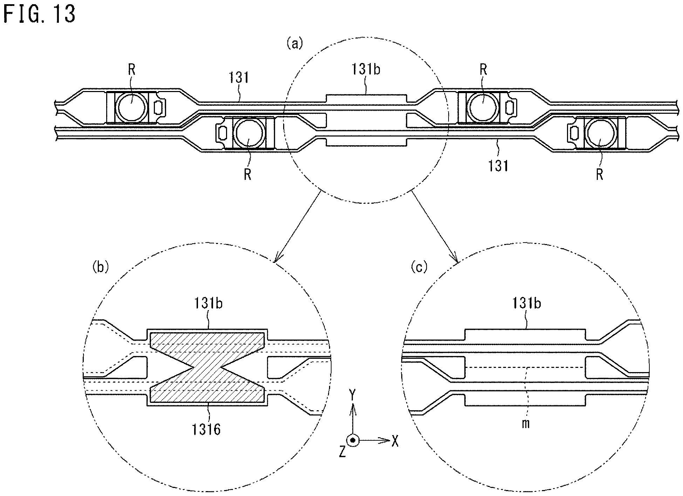

FIG. 13 is a plan view of the connection band 131b before separation, focusing only on two adjacent flexible substrates 131. In FIG. 13, (b) is an enlarged view showing an example of the back face in (a). In (b), a copper pattern 1316 (hatched portion) having a shape as shown in the drawing is provided on the back face of the connection band 131b so as to be in close contact therewith. In this case, the connection band 131b is easily cut at the intermediate position in the Y direction so as to be parallel to the X direction. However, it is difficult to cut the connection band 131b at a position other than the intermediate position in the Y direction. Therefore, cutting or tearing (spread) that results in an unintended end face shape is less likely to occur, and the certainty that cutting with a desired end face shape is performed can be increased.

In FIG. 13, (c) is an enlarged view as an example of the front face side in (a). A perforation m is formed at the intermediate position in the Y direction of the connection band 131b so as to be parallel to the X direction. In this case as well, the connection band 131b is easily cut at the intermediate position in the Y direction so as to be parallel to the X direction. However, it is difficult to cut the connection band 131b at a position other than the intermediate position in the Y direction. Therefore, cutting or tearing (shift) that results in an unintended end face shape is less likely to occur, and the certainty that cutting with a desired end face shape is performed can be increased. Moreover, in this case, the connection band 131b can be easily cut even without using a machine dedicated for cutting.

### <<Positioning with connection band as mark>>

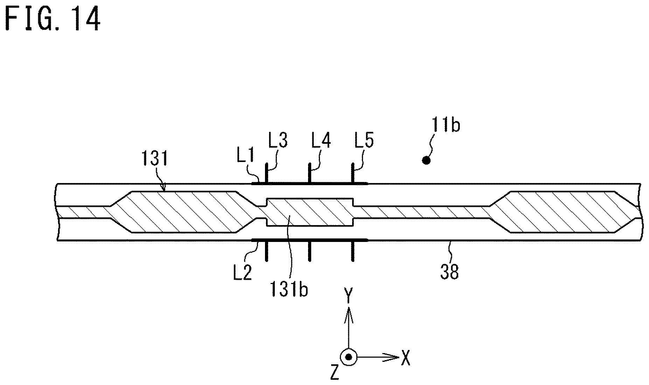

FIG. 14 is a plan view showing a first example of a positioning procedure using the connection band 131b remaining at the flexible substrate 131. A hatched portion is the flexible substrate 131 (the same applies below). If, for example, an aluminum alloy is used as the material of the bottom surface 11b of the housing 11 (FIG. 4), a scratching line can be easily added to the bottom surface 11b (the same applies below). Therefore, scratching lines L1, L2, L3, L4, and L5 are added in advance.

When attaching the heat radiation tape 38, both ends in the Y direction of the heat radiation tape 38 are aligned with the scratching lines L1 and L2. Furthermore, when mounting the flexible substrate 131, the connection band 131b can be positioned in the X direction on the basis of the positional relationship between both ends in the X direction of the connection band 131b and the scratching lines L3 and L5 and the positional relationship between the center in the X direction of the connection band 131b and the scratching line L4. Moreover, if the gaps between the scratching lines L1 and L2 and both ends in the Y direction of the connection band 131b are made uniform, the connection band 131b can also be positioned in the Y direction.

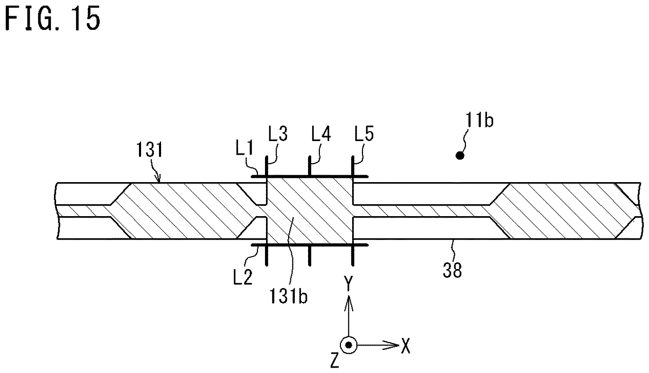

FIG. 15 is a plan view of a second example of the positioning procedure using the connection band 131b remaining at the flexible substrate 131. Also in this case, scratching lines L1, L2, L3, L4, and L5 are added in advance.

When attaching the heat radiation tape 38, the gaps between the scratching lines L1 and L2 and both ends in the Y direction of the heat radiation tape 38 are made uniform. Furthermore, when mounting the flexible substrate 131, both ends in the X direction of the connection band 131b are aligned with the scratching lines L3 and L5, and the center in the X direction of the connection band 131b is also aligned with the scratching line L4. In this manner, positioning in the X direction can be performed. Moreover, by aligning both ends in the Y direction of the connection band 131b with the scratching lines L1 and L2, the connection band 131b can be positioned in the Y direction.

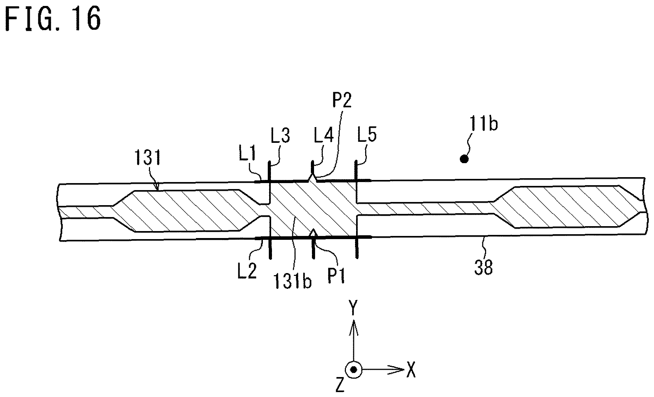

FIG. 16 is a plan view showing a third example of the positioning procedure using the connection band 131b remaining at the flexible substrate 131. In the connection band 131b, a triangular recess P1 and a triangular projection P2 are formed at the center in the X direction on both ends in the Y direction. Such a recess and projection can be easily formed when cutting the connection band 131b. Also in this case, scratching lines L1, L2, L3, L4, and L5 are added in advance.

When attaching the heat radiation tape 38, both ends in the Y direction of the heat radiation tape 38 are aligned with the scratching lines L1 and L2. Furthermore, when mounting the flexible substrate 131, both ends in the X direction of the connection band 131b are aligned with the scratching lines L3 and L5, and the recess P1 and the projection P2 of the connection band 131b are aligned with the scratching line L4. In this manner, positioning in the X direction can be performed more accurately. Moreover, by aligning both ends in the Y direction of the connection band 131b with the scratching lines L1 and L2, the connection band 131b can be positioned in the Y direction.

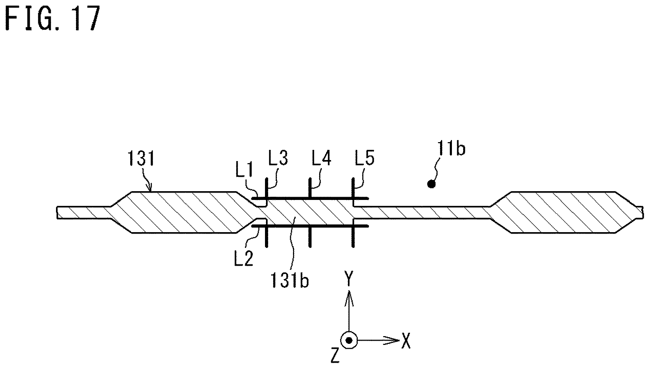

FIG. 17 is a plan view showing a fourth example of the positioning procedure using the connection band 131b remaining at the flexible substrate 131. This is an example in which a heat radiation tape is not used. Also in this case, scratching lines L1, L2, L3, L4, and L5 are added in advance. When mounting the flexible substrate 131 to the bottom surface 11b, both ends in the X direction of the connection band 131b are aligned with the scratching lines L3 and L5, and the center in the X direction of the connection band 131b is also aligned with the scratching line L4. In this manner, positioning in the X direction can be performed. Moreover, by aligning both ends in the Y direction of the connection band 131b with the scratching lines L1 and L2, the connection band 131b can be positioned in the Y direction.

The "scratching" in FIG. 14 to FIG. 17 is an example, and marks may be formed by other methods such as marking.

### <<Conclusion>>

As described in detail above, the precursor body 13A of the flexible printed circuit of the present embodiment includes a plurality of connection bands 131b that connect a plurality of flexible substrates 131 to each other in a state where the plurality of flexible substrates 131 are aligned so as to be close to each other in the Y direction orthogonal to the X direction in which the flexible substrates 131 extend, and that extend in the Y direction.

In the precursor body 13A, of the flexible printed circuit, including such connection bands 131b, since the plurality of flexible substrates 131 are connected by the connection bands 131b, the plurality of flexible substrates 131 are inhibited from overlapping each other or twisting, and thus can be handled as a single sheet. Therefore, it is easy to handle the precursor body of the flexible printed circuit 13 even when a release paper is not used.

When mounting to an installation target, each connection band 131b is cut at the intermediate position between two adjacent flexible substrates 131 such that the two adjacent flexible substrates 131 are separated from each other in the Y direction, and the plurality of flexible substrates 13 separated from each other are developed into a desired shape, thereby forming the flexible printed circuit 13.

The connection bands 131b remaining after separation can serve as marks for proper mounting or positioning of the flexible printed circuit 13 (flexible substrates 131), and also have the effect of making the adhesion of the entire flexible printed circuit 13 strong, when the connection bands 131b are adhered to an installation surface.

### <<Others>>

In the above embodiment, the concentrator photovoltaic modules 1M have been described. The configuration in which the precursor body 13A of the flexible printed circuit 13 shown in FIG. 7 is developed and placed on the bottom surface of the module is also applicable to a light emitting module. In the case of the light emitting module, a light emitting element such as an LED (Light Emitting Diode) is disposed instead of each light receiving portion R in FIG. 7. The light emitting module can be configured when: a precursor body, of a flexible printed circuit, on which LEDs are mounted is developed and placed on the bottom surface of the module; and, for example, a non-clear light-transmissive plate such as frosted glass is used instead of the concentrating portion 12 (FIG. 4). Power is, for example, supplied from the outside to cause the LEDs to emit light.

### <<Supplementary note>>

The above embodiment is merely illustrative in all aspects and should not be recognized as being restrictive. The scope of the present disclosure is defined by the scope of the claims, and is intended to include meaning equivalent to the scope of the claims and all modifications within the scope.

### REFERENCE SIGNS LIST

- 1: array
- 1M: concentrator photovoltaic module (module)
- 1U: concentrator photovoltaic unit
- 2: support device
- 11: housing
- 11b: bottom surface
- 12: concentrating portion
- 12a: glass plate
- 12f: primary lens
- 13: flexible printed circuit
- 13A: precursor body
- 13A1, 13A2: precursor body
- 14: shielding plate
- 14a: opening
- 21: post
- 22: base
- 23: biaxial drive part
- 24: horizontal shaft
- 25: tracker
- 25a: reinforcement member
- 25b: rail
- 30: secondary lens
- 31: support portion
- 31a: end face
- 31c: recess
- 31e: upper end inner peripheral edge
- 32: package
- 33: cell
- 34: lead frame
- 35: gold wire
- 36: lead frame
- 37: sealing portion
- 38: heat radiation tape
- 39: bypass diode
- 100: photovoltaic apparatus
- 131: flexible substrate
- 131b: connection band
- 131c: folded portion
- 131n: narrow portion
- 131p: printed circuit unit
- 131w: wide portion
- 131x: margin portion
- 1311: copper pattern
- 1312: insulating base portion
- 1313: copper pattern
- 1314: adhesive layer
- 1315: cover lay
- 1316: copper pattern
- Ax: optical axis
- m: perforation
- P1: recess
- P2: projection
- R: light receiving portion

## Claims

1. A precursor body, of a flexible printed circuit, which is developed and provided on a bottom surface of a housing of a concentrator photovoltaic module for concentrating sunlight and generating power, the precursor body comprising:
a plurality of strip-shaped flexible substrates extending in an X direction when one direction is defined as the X direction;
a printed circuit unit including a plurality of cells mounted on the flexible substrates at equal intervals in the X direction and an electric circuit related to the cells; and
a plurality of connection bands connecting the plurality of flexible substrates to each other in a state where the plurality of flexible substrates are aligned so as to be close to each other in a Y direction orthogonal to the X direction, the plurality of connection bands extending in the Y direction.

2. The precursor body of the flexible printed circuit according to claim 1, wherein a copper pattern having a shape that makes it easy to cut the copper pattern at an intermediate position in the Y direction and that makes it difficult to cut the copper pattern at a position other than the intermediate position is provided on one face of each connection band.

3. The precursor body of the flexible printed circuit according to claim 1, wherein a perforation is formed at an intermediate position in the Y direction of each connection band.

4. A manufacturing method for a flexible printed circuit, comprising:
mounting a printed circuit unit including an electric circuit, on a plurality of strip-shaped flexible substrates extending in an X direction when one direction is defined as the X direction;
preparing a precursor body of the flexible printed circuit by, in a state where the plurality of flexible substrates are aligned so as to be close to each other in a Y direction orthogonal to the X direction, making the plurality of flexible substrates connected to each other by a plurality of connection bands extending in the Y direction;
cutting each of the connection bands at an intermediate position between two adjacent flexible substrates such that the flexible substrates are separated from each other in the Y direction, when mounting to an installation target; and
developing the plurality of flexible substrates separated from each other, into a desired shape to form the flexible printed circuit.

5. The manufacturing method for the flexible printed circuit according to claim 4, wherein the connection band is cut such that a recess or a projection is left at a cut portion in the Y direction of the connection band at the adjacent flexible substrates.

6. The manufacturing method for the flexible printed circuit according to claim 4, wherein a mark with which the connection band after separation is aligned is formed on an installation surface of the installation target.

7. A concentrator photovoltaic module for concentrating sunlight and generating power, the concentrator photovoltaic module comprising:
a housing;
a concentrating portion mounted so as to face a bottom surface of the housing; and
a flexible printed circuit provided on the bottom surface of the housing so as to form a plurality of rows, wherein
the flexible printed circuit in each row includes
a strip-shaped flexible substrate extending in an X direction when one direction is defined as the X direction,
a printed circuit unit including a plurality of cells which are mounted on the flexible substrate at equal intervals in the X direction and are for performing photoelectric conversion by sunlight concentrated by the concentrating portion and an electric circuit related to the cells, and
a remnant of a connection band remaining at the flexible substrate and extending in a Y direction orthogonal to the X direction.

8. A light emitting module for emitting light upon receiving power supplied from outside, the light emitting module comprising:
a housing;
a light-transmissive plate mounted so as to face a bottom surface of the housing; and
a flexible printed circuit provided on the bottom surface of the housing so as to form a plurality of rows, wherein
the flexible printed circuit in each row includes
a strip-shaped flexible substrate extending in an X direction when one direction is defined as the X direction,
a printed circuit unit including light emitting elements mounted on the flexible substrate at equal intervals in the X direction and an electric circuit related to the light emitting elements, and
a remnant of a connection band remaining at the flexible substrate and extending in a Y direction orthogonal to the X direction.
